(19) Europäisches Patentamt
European Patent Office
Office européen des brevets

(11) **EP 4 346 057 A1**

(12) **EUROPEAN PATENT APPLICATION**

(43) Date of publication:
**03.04.2024 Bulletin 2024/14**

(21) Application number: **23188726.6**

(22) Date of filing: **31.07.2023**

(51) International Patent Classification (IPC):
*H02J 7/00* (2006.01)

(52) Cooperative Patent Classification (CPC):
**H02J 7/0016; G01R 31/389; G01R 31/392;**
G01R 31/396; H02J 7/0047

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.09.2022 KR 20220125289**

(71) Applicant: **Chungbuk National University
Industry-Academic
Cooperation Foundation
Cheongju-si, Chungcheongbuk-do 28644 (KR)**

(72) Inventors:
• **KEE, Seok Cheol
06798 Seoul (KR)**
• **YUN, Sang Sun
28650 Cheongju-si, Chungcheongbuk-do (KR)**

(74) Representative: **BCKIP Part mbB
Siegfriedstraße 8
80803 München (DE)**

(54) **METHOD OF MEASURING INTERNAL RESISTANCE OF BATTERY CELL AND DEVICE THEREFOR**

(57)    A method of measuring an internal resistance of a battery cell and a device therefor are provided. A battery management device includes one or more passive balancing circuits provided for each of one or more battery cells, wherein each passive balancing circuit includes a balancing resistor and a switching element for selectively discharging each battery cell through the balancing resistor, and a control unit configured to determine an alternating current internal resistance of a target battery cell that is subject to cell balancing based on a voltage of the target battery cell before and after a target switching element that is the switching element corresponding to the target battery cell is turned on, and determine a direct current internal resistance of the target battery cell based on an amount of change in the voltage of the target battery cell during a time period after a predetermined time elapses from a time point when the target switching element is turned on.

EP 4 346 057 A1

**Description**

## TECHNICAL FIELD

The present disclosure relates to a method of measuring an internal resistance of a battery and a device therefor.

## BACKGROUND

The contents described below merely provide background information related to the present embodiment and do not constitute prior art.

As a battery is applied to various fields such as an electric vehicle, more accurate measurement of the state of charge (SOC) and state of health (SOH) of the battery is required. To this end, a method of calculating the state of health of a battery by measuring an internal resistance (IR) of the battery has emerged.

There are two methods for measuring the internal resistance of a battery, that is, a direct current method and an alternating current method. An internal resistance measured by the direct current method is referred to as a direct current internal resistance (DCIR), and an internal resistance measured by the alternating current method is referred to an alternating current internal resistance (ACIR). In the direct current method, the DCIR is calculated by applying a specific constant current in the form of a pulse to the battery and measuring a drop or a rise in battery voltage after a certain period of time has elapsed. In the alternating current method, the ACIR is calculated by applying alternating current with a specific frequency to the battery and measuring a voltage across the battery.

In an existing battery management system (BMS), the direct current method is mainly used. However, when using the direct current method, the battery is charged or discharged while a specific constant current is applied. That is, when the battery is charged with a DC current, an internal resistance value is changed according to a measurement time because the battery is being charged. Similarly, when the battery is discharged with a DC current, the internal resistance value changes according to the measurement time because the battery is being discharged. In this way, in the direct current internal resistance measurement method, since the state of health of the battery changes while charging and discharging with a direct current, the internal resistance value also changes according to the measurement delay time, the amount of charge also changes, and there is a problem that the voltage for calculating the internal resistance value does not reach stabilization. Meanwhile, while operating a motor to drive a vehicle in an electric vehicle, current fluctuates severely. In addition, since the constant current value for charging is different for each vehicle, a serious error occurs.

## SUMMARY

The present disclosure provides a method of measuring an internal resistance of a battery cell capable of performing more accurate internal resistance measurement in a shorter time and a device therefor.

The features of the present disclosure are not limited to the features mentioned above, and other features not mentioned will be clearly understood by those skilled in the art from the description below.

According to an aspect of the present disclosure provides a battery management device. The battery management device includes one or more passive balancing circuits provided for each of one or more battery cell and a control unit. Each passive balancing circuit includes a balancing resistor and a switching element for selectively discharging each battery cell through the balancing resistor. The control unit is configured to determine an alternating current internal resistance of a target battery cell that is subject to cell balancing based on a voltage of the target battery cell before and after a target switching element that is the switching element corresponding to the target battery cell is turned on, and determine a direct current internal resistance of the target battery cell based on an amount of change in the voltage of the target battery cell during a time period after a predetermined time elapses from a time point when the target switching element is turned on. The control unit controls a plurality of target switching elements corresponding to a plurality of target battery cells which are selected from among the battery cells included in a battery stack together so that cell balancing for the plurality of target battery cells is performed simultaneously and determines internal resistances of the plurality of target battery cells based on simultaneously measured voltages for the plurality of target battery cells.

According to another aspect of the present disclosure provides a method of an internal resistance of a battery. The method including measuring a voltage of a target battery cell that is subject to cell balancing, turning on a switching element of a passive balancing circuit corresponding to the target battery cell, measuring a voltage of the target battery cell after the target switching element is turned on, determining an alternating current internal resistance of the target battery cell based on the measured voltages, and determining a direct current internal resistance of the target battery cell based on an amount in change of the voltage of the target battery cell during a time period after a predetermined time elapses from a time when the switching element is turned on. Wherein in the turning on of the target switching element, a plurality of switching elements corresponding to a plurality of target battery cells, which are selected from among a plurality of battery cells included in a battery stack, are controlled together so that cell balancing for the plurality of target battery cells is performed at the same time. Wherein in the determining of the alternating current internal resistance, the internal resistances of the plurality of target battery cells are determined based on simultaneously measured voltages.

According to one embodiment of the present disclosure, there is an effect that more accurate internal resistance measurement is possible within a shorter time.

According to one embodiment of the present disclosure, cell balancing may be performed using passive balancing circuits included in an existing battery management system, and an internal resistance of a cell may be measured. In addition, the method and device according to one embodiment of the present disclosure can be implemented only by changing the software of an existing battery management system, thereby reducing costs.

The effects of the present disclosure are not limited to the effects mentioned above, and other effects not mentioned will be clearly understood by those skilled in the art from the description below.

## BRIEF DESCRIPTION OF THE DRAWINGS

FIG. 1 is a schematic block diagram illustrating one example of a battery management device according to one embodiment of the present disclosure.

FIG. 2 is an equivalent circuit diagram illustrating one example of a battery cell according to one embodiment of the present disclosure.

FIG. 3 is a waveform diagram for explaining one example of a method of measuring an internal resistance according to one embodiment of the present disclosure.

FIG. 4 is a flowchart illustrating one example of a method of measuring the internal resistance of the battery cell according to one embodiment of the present disclosure.

FIG. 5 is a flowchart illustrating one example of a method of measuring an internal resistance of each battery cell in a battery stack according to one embodiment of the present disclosure.

REFERENCE NUMERALS

| 10: | battery management device | 14: | battery stack |
|---|---|---|---|
| 100: | passive balancing circuit | 120: | control unit |

## DETAILED DESCRIPTION

Hereinafter, some embodiments of the present disclosure are described in detail using exemplary drawings. In adding reference numerals to components of each drawing, it should be noted that the same components have the same numerals as possible even when they are displayed on different drawings. In addition, in describing the present disclosure, when it is determined that a detailed description of a related known configuration or function may obscure the gist of the present disclosure, the detailed description will be omitted.

In describing the components of the embodiment according to the present disclosure, symbols such as first, second, i), ii), a), and b) may be used. These codes are only for distinguishing the component from other components, and the nature or sequence or order of the corresponding component is not limited by the codes. In the specification, when a part is said to "include" or "have" a certain component, it means that it may further include other components, not excluding other components unless explicitly stated otherwise.

The detailed description set forth below in conjunction with the accompanying drawings is intended to describe exemplary embodiments of the present disclosure, and is not intended to represent the only embodiments in which the present disclosure may be practiced.

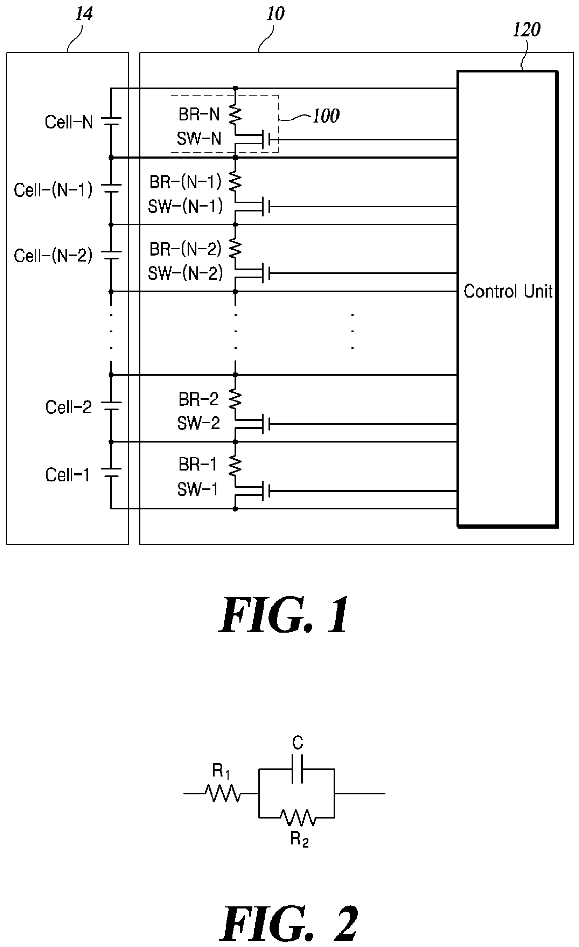

FIG. 1 is a schematic block diagram illustrating one example of a battery management device according to one embodiment of the present disclosure.

Referring to FIG. 1, a battery management device 10 may include all or some of one or more passive balancing circuits 100 and a control unit 120. Not all blocks illustrated in FIG. 1 are essential components, and some blocks included in the battery management device 10 may be added, changed, or deleted in another embodiment. That is, FIG. 1 exemplarily illustrates components for measuring an internal resistance of a battery cell using a passive balancing circuit 100, and it should be recognized that the battery management device 10 may have more or less components than those illustrated or a configuration of different components to implement other functions.

Meanwhile, in FIG. 1, the battery management device 10 is illustrated as measuring states of respective battery cells Cell-1 to Cell-N included in one battery stack 14, but this is for convenience of description, and the present disclosure is not intended to be limited thereto. That is, the battery management device 10 may be configured to measure states of battery cells included in a plurality of battery stacks.

A passive balancing circuit 100 may be provided for respective battery cells Cell-1, Cell-2, Cell-3, Cell-(N-1), or Cell-N. Each passive balancing circuit 100 may include a balancing resistor BR-1, BR-2, BR-3, BR-(N-1), or BR-N and a switching element SW-1, SW-2, SW-3, SW-(N-1), or SW-N for selectively discharges corresponding battery cell Cell-1, Cell-2, Cell-3, Cell-(N-1), or Cell-N through the balancing resistor BR-1, BR-2, BR-3, BR-(N-1), or BR-N. Here, the switching elements SW-1 to SW-N may be transistors, but are not limited thereto.

The control unit 120 may generate a control signal for turning on or off the switching elements SW-1 to SW-N.

The control unit 120 may measure the states of each of the battery cells Cell-1 to Cell-N. The state of the battery cell may include, for example, internal resistance, SOC, SOH, and/or temperature. The control unit 120 may include a memory for storing instructions and at least one processor. In addition, the control unit 120 may further include an analog-to-digital converter (ADC) that converts the voltage at both ends of the battery cell into a digital signal. As another example, the analog-to-digital converter may be separately provided between the battery cells Cell-1 to Cell-N and the control unit 120.

The control unit 120 may turn on one or more target switching element SW-n, where n is a natural number of N or less, corresponding to one or more target battery cells Cell-n to be balanced among the plurality of battery cells Cell-1 to Cell-N. The control unit 120 may determine an alternating current internal resistance (ACIR) of each target battery cell Cell-n based on voltages of each target battery cell Cell-n measured before and after each target switching element SW-n is turned on.

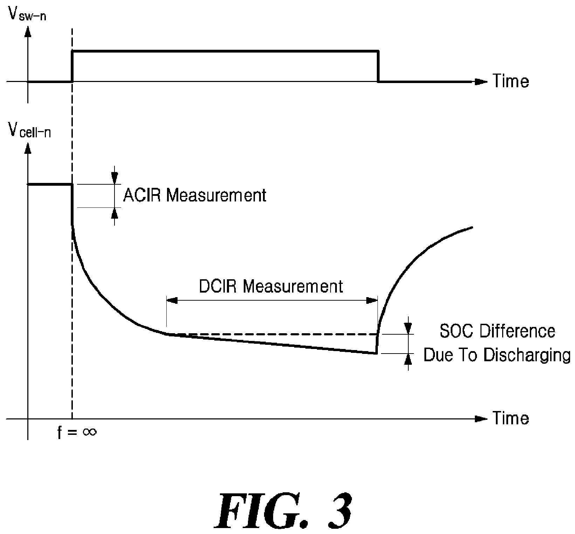

Hereinafter, with reference to FIGS. 2 and 3, a method of measuring the internal resistance of the target battery cell using the control unit 120 will be described.

FIG. 2 is an equivalent circuit diagram illustrating one example of the battery cell according to one embodiment of the present disclosure.

FIG. 3 is a waveform diagram for explaining one example the method of measuring the internal resistance according to one embodiment of the present disclosure.

As illustrated in FIG. 2, each of the battery cells Cell-1 to Cell-N can be expressed as an R-RC equivalent circuit including an equivalent series resistor R1 and an RC parallel circuit in which a leak resistor R2 and an equivalent capacitor C are connected in parallel. When the target switching element SW-n connected to the target battery cell Cell-n is turned on, a discharge path is formed through the balancing resistor BR-n. Accordingly, a voltage $V_{cell-n}$ of the target battery cell descends momentarily, and then the voltage $V_{cell-n}$ is stabilized as illustrated in FIG. 3.

When the target switching element SW-n is turned on, a current whose frequency is close to infinity flows in the target battery cell Cell-n. Therefore, since the impedance of the equivalent capacitor C of the target battery cell approaches 0 at the time when the target switching element SW-n is turned on, a leakage resistor R2 can be ignored by current distribution, and only the magnitude of the equivalent series resistor R1 can be measured.

Due to this point, the control unit 120 may measure the instantaneous drop of the voltage $V_{Cell-n}$ of the target battery cell at the time when the target switching element SW-n is turned on to calculate the ACIR of the target battery cell Cell-n.

For example, the control unit 120 may be configured to measure the voltage $V_{Cell-n}$ of the target battery cell for each cycle with a preset period. The control unit 120 may determine the ACIR of the target battery cell Cell-u using a difference between the voltage $V_{Cell-n}$ measured in a cycle immediately before the target switching element SW-n is turned on and the voltage $V_{Cell-n}$ measured in a cycle immediately after the target switching element SW-n is turned on.

As the target switching element SW-n is turned on, the control unit 120 may determine the ACIR based on a ratio in which the voltage $V_{Cell-n}$ of the target battery cell is divided into the equivalent series resistance R1 of the target battery cell Cell-n and the balancing resistor BR-n connected to the target switching element SW-n. For example, the control unit 120 may determine the ACIR of the target battery cell Cell-n, that is, the resistance of the equivalent series resistor R1, based on Equation 1.

[Equation 1]

$$R1 = \frac{v_1 - v_2}{v_2} \cdot BR$$

4

In Equation 1, v1 is the voltage difference between both ends of the target battery cell Cell-n measured before the target switching element SW-n is turned on, v2 is the voltage difference between both ends of the target battery cell Cell-n measured after the target switching element SW-n is turned on, and BR is the resistance of the balancing resistor BR-n. To this end, the control unit 120 may store resistance of each of the balancing resistors BR-1 to BR-N included in the passive balancing circuit 100 in advance.

The control unit 120 may measure the direct current internal resistance (DCIR) of the target battery cell Cell-n. For example, as illustrated in FIG. 3, the control unit 120 may determine the DCIR based on an amount of change in the voltage $V_{Cell-n}$ of the target battery cell during a time period after a predetermined time has elapsed from a time point when the target switching element SW-n is turned on.

The control unit 120 may simultaneously measure the ACIRs of one or more target battery cells selected from among the plurality of battery cells Cell-1 to Cell-N included in the battery stack 14. For example, the control unit 120 may open a relay (not illustrated) connecting the battery stack 14 in parallel with another battery stack (not illustrated) before measuring the ACIR. The control unit 120 may select, from among a group of odd-numbered battery cells Cell-(2i+1), where i is a natural number equal to or less than (N-1)/2, and a group of even-numbered battery cells Cell-(2j), where j is a natural number equal to or less than N/2, in the battery stack 14, a group including a battery cell having the highest voltage at both ends as a first group and select another group as a second group. The control unit 120 may turn on switching elements corresponding to battery cells in the first group to determine the ACIR of the battery cell in the first group, and turn on switching elements corresponding to battery cells in the second groups to determine the ACIR of the battery cells, after turning off the switching elements corresponding to battery cells in the first group.

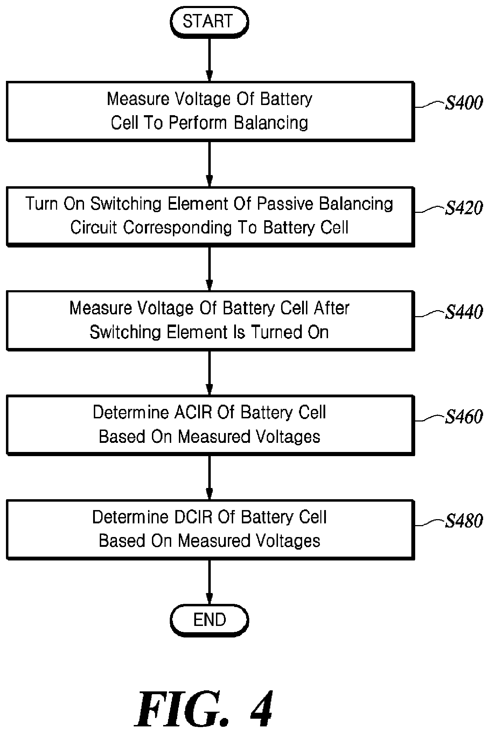

FIG. 4 is a flowchart illustrating one example of a method of measuring the internal resistance of the battery cell according to one embodiment of the present disclosure.

Since the method illustrated in FIG. 4 may be performed by the control unit 120 and/or the battery management device 10 described above, detailed descriptions of overlapping descriptions are omitted.

The battery management device 10 may measure the voltage of a battery cell (hereinafter, a target battery cell) to perform balancing (S400). At this time, a switching element of the passive balancing circuit corresponding to the target battery cell may be in an off state.

The battery management device 10 may turn on the switching element of the passive balancing circuit corresponding to the target battery cell (S420).

The battery management device 10 may measure the voltage of the target battery cell after the switching element is turned on (S440).

The battery management device 10 may determine an ACIR of the target battery cell (S460). The ACIR may be calculated based on the voltages measured in Step 400 and Step S440. For example, as the switching element is turned on, the battery management device 10 may determine the ACIR based on a ratio in which the voltage of the target battery cell is divided to the equivalent series resistance component of the target battery cell and the balancing resistor connected to the switching element.

The battery management device 10 may determine the DCIR of the target battery cell (S480). The DCIR may be calculated based on the amount of change in voltage of the target battery cell during the time period after a predetermined time has elapsed from the time the target switching element is turned on.

Meanwhile, the battery management device 10 may control the switching elements corresponding to each target battery cell together so that cell balancing of the plurality of target battery cells selected from among the plurality of battery cells included in the battery stack 14 is performed simultaneously to measure voltages of the plurality of target battery cells for calculating ACIRs and/or DCIRs at the same time.

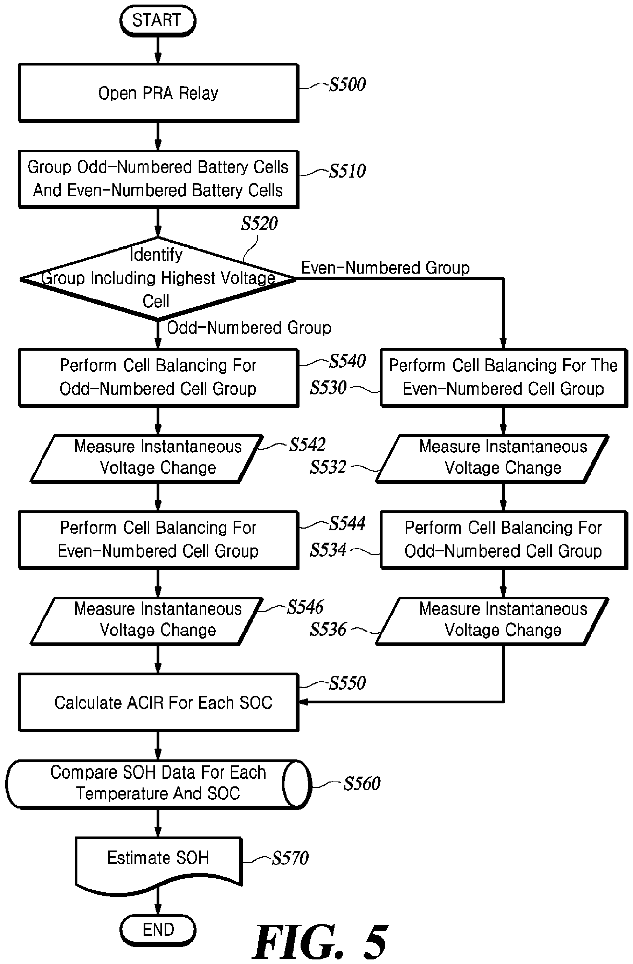

FIG. 5 is a flowchart illustrating one example of a method of measuring the internal resistance of each battery cell in the battery stack according to one embodiment of the present disclosure.

Since the method illustrated in FIG. 5 may be performed by the control unit 120 and/or the battery management device 10 described above, detailed descriptions of overlapping descriptions are omitted.

The battery management device 10 may open a Power Relay Assembly (PRA) relay connecting the battery stack 14 in parallel with another battery stack (S500). When the cell balancing is performed in a state where the battery stacks are connected in parallel, a compensating current flows into the battery stack with a relatively lower total voltage, and this current value increases in proportion to the difference in the number of cell balances, resulting in errors in internal resistance measurement. In the present disclosure, by opening the relay between the battery stacks prior to the internal resistance measurement using the passive balancing circuit, it is possible to prevent inflow (or outflow) of a compensating current generated by breakdown of voltage equalization due to cell balancing progresses.

The battery management device 10 may group odd-numbered battery cells and even-numbered battery cells in the battery stack 14 (S510).

The battery management device 10 may identify a group including a battery cell (hereinafter, referred to as the "highest voltage cell") having the highest voltage at both ends among the odd-numbered cell groups and the even-numbered cell groups (S520).

When the group including the highest voltage cell is the even-numbered cell group, the battery management device 10 may perform cell balancing for the even-numbered cell group (S530). The battery management device 10 may turn on a switching element corresponding to at least one battery cell (hereinafter referred to as a first target battery cell) among the battery cells in an even numbered cell group.

The battery management device 10 may measure an instantaneous voltage change of the first target battery cell as the switching element is turned on (S532). For example, the battery management device 10 may measure the voltage of the first target battery cell for each preset period, and measure, as the instantaneous voltage change, a difference between the voltage measured in the period immediately before the switching element is turned on and the voltage measured in the period immediately after the switching element is turned on. According to implementation examples, the battery management device 10 may also measure the SOC and/or temperature of the first target battery cell.

Next, the battery management device 10 may perform cell balancing for odd-numbered cell groups (S534). After the battery management device 10 turns off the switching elements corresponding to the first target battery cells, the battery management device 10 may turn on switching elements corresponding to at least one battery cell (hereinafter, referred to as a second target battery cell) among battery cells in the odd-numbered cell group.

The battery management device 10 may measure the instantaneous voltage change of the second target battery cell as the switching element is turned on (S536). For example, the battery management device 10 may measure the voltage of the second target battery cell for each preset period, and measure, as the instantaneous voltage change, a difference between the voltage measured in the period immediately before the switching element is turned on and the voltage measured in the period immediately after the switching element is turned on. According to implementation examples, the battery management device 10 may also measure the SOC and/or temperature of the second target battery cell.

Meanwhile, when the group including the highest voltage cell is the odd-numbered cell group, the battery management device 10 may perform cell balancing for the odd-numbered cell group (S540). The battery management device 10 may turn on switching elements corresponding to the second target battery cell that is at least one or more battery cells among battery cells in the odd-numbered cell group.

The battery management device 10 may measure the instantaneous voltage change of the second target battery cell as the switching element is turned on (S542).

Next, the battery management device 10 may perform cell balancing for even-numbered cell groups (S544). After the battery management device 10 turns off the switching elements corresponding to the second target battery cells, the battery management device 10 turn on a switching element corresponding to at least one battery cell (hereinafter, referred to as a first target battery cell) among the battery cells in the even-numbered cell group.

The battery management device 10 may measure the instantaneous voltage change of the first target battery cell as the switching element is turned on (S546).

The battery management device 10 may calculate the ACIR for each SOC using the instantaneous voltage and SOC of each battery cell (S550). The battery management device 10 may compare data for each temperature and SOC (S560) and estimate the SOH of each battery (S570). For example, the battery management device 10 may estimate that the aging of the corresponding battery cell has progressed considerably when the ACIR of a specific battery cell is greater than those of other battery cells of the same SOC. As another example, the battery management device 10 may estimate the SOH of each battery by referring to a table in which SOH according to the temperature, SOC, and internal resistance of the battery cell is stored.

As described above, the battery management device 10 does not simultaneously measure the internal resistances of consecutive battery cells, that is, directly series-connected battery cells, in the battery stack 14 including series-connected battery cells and thus, it is possible to prevent unintentional occurrence of current loops, and measurement errors and accidents caused by such occurrences.

Each component of the device or method according to the present disclosure may be implemented as hardware or software, or a combination of hardware and software. Moreover, the function of each component may be implemented as software, and the microprocessor may be implemented to execute the software function corresponding to each component.

Various implementations of the systems and techniques described herein may include a digital electronic circuit, an integrated circuit, a field programmable gate arrays (FPGA), an application specific integrated circuit (ASIC), computer hardware, a firmware, software, and/or a combination thereof. These various implementations may include being implemented as one or more computer programs executable on a programmable system. The programmable system includes at least one programmable processor (which may be a special purpose processor or may be a general-purpose processor) coupled to receive data and instructions from and transmit data and instructions to a storage system, at least one input device, and at least one output device. Computer programs (also known as programs, software, software applications or code) contain instructions for a programmable processor and are stored on a "computer readable medium".

A computer-readable recording medium includes all types of recording devices in which data that can be read by a computer system is stored. These computer-readable recording media include non-volatile or non-transitory media such as ROM, CD-ROM, magnetic tape, floppy disk, memory card, hard disk, magneto-optical disk, and storage device, and may be a medium, and may further include a transitory medium such as a data transmission medium. Also, the computer-readable recording media may be distributed in computer systems connected through a network, and computer-readable codes may be stored and executed in a distributed manner.

In the flow chart/timing diagram of the present specification, it is described that each process is sequentially executed, but this is merely an example of the technical idea of one embodiment of the present disclosure. In other words, those skilled in the art to which one embodiment of the present disclosure belongs can change and execute the order described in the flowchart/timing diagram within the range that does not deviate from the essential characteristics of the embodiment of the present disclosure, or can execute one or more process in parallel to apply various modifications and variations, and thus, the flow chart/timing chart is not limited to a time-series sequence.

The above description is merely an example of the technical idea of the present embodiment, and those skilled in the art to which the present embodiment pertains may make various modifications and variations to the present embodiment without departing from the essential characteristics of the present embodiment. Therefore, the present embodiments are not intended to limit the technical idea of the present embodiment, but to explain, and the scope of the technical idea of the present embodiment is not limited by these embodiments. The scope of protection of this embodiment should be construed according to the claims below, and all technical ideas within the scope equivalent thereto should be construed as being included in the scope of rights of the present embodiment.

**Claims**

1. A battery management device comprising:

    one or more passive balancing circuits (100) provided for each of one or more battery cells (Cell-1, ..., Cell-N), wherein each passive balancing circuit (100) includes a balancing resistor (BR-1, ..., BR-N) and a switching element (SW-1, ..., SW-N) for selectively discharging each battery cell (Cell-1, ..., Cell-N) through the balancing resistor (BR-1, ..., BR-N); and
    a control unit (120) configured to:

        determine an alternating current internal resistance of a target battery cell that is subject to cell balancing based on a voltage of the target battery cell before and after a target switching element that is the switching element corresponding to the target battery cell is turned on, and
        determine a direct current internal resistance of the target battery cell based on an amount of change in the voltage of the target battery cell during a time period after a predetermined time elapses from a time point when the target switching element is turned on,

    wherein the control unit (120) controls a plurality of target switching elements corresponding to a plurality of target battery cells which are selected from among the battery cells (Cell-1, ... , Cell-N) included in a battery stack (14) together so that cell balancing for the plurality of target battery cells is performed simultaneously and determines internal resistances of the plurality of target battery cells based on simultaneously measured voltages for the plurality of target battery cells.

2. The battery management device of claim 1, wherein the control unit (120) measures the voltage of the target battery cell for each cycle with a preset period, and determines the alternating current internal resistance using a difference between the voltage of the target battery cell measured in a first cycle immediately before the target switching element is turned on and the voltage of the target battery cell measured in a second cycle immediately after the target switching element is turned on.

3. The battery management device of claim 1, wherein the control unit (120) determines the alternating current internal resistance based on a ratio in which the voltage of the target battery cell is divided into an equivalent series resistor ($R_1$) of the target battery cell and a target balancing resistor connected to the target switching element when the target switching element is turned on.

4. The battery management device of any one of claims 1 to 3, wherein the control unit (120) is further configured to:

    open a relay connecting the battery stack (140) in parallel with another battery stack prior to measuring the alternating current internal resistance;
    select, from among an odd-numbered group including odd-numbered battery cells in the battery stack (140) and an even-numbered group including even-numbered battery cells in the battery stack (140), a group including a highest voltage battery cell that is a battery cell having a highest voltage among the one or more battery cells (Cell-1, ..., Cell-N) as a first group, and select another group as a second group;
turn on first switching elements corresponding to first battery cells in the first group,
determine the alternating current internal resistance of the first battery cells;
turn off the first switching elements;
turn on second switching elements corresponding to second battery cells in the second group; and
determine the alternating current internal resistance of the second battery cells.

5. A method for measuring an internal resistance of a battery, the method comprising:

measuring a voltage of a target battery cell that is subject to cell balancing (S400);
turning on a switching element of a passive balancing circuit (100) corresponding to the target battery cell (S420);
measuring a voltage of the target battery cell after the target switching element is turned on (S440);
determining an alternating current internal resistance of the target battery cell based on the measured voltages (S460); and
determining a direct current internal resistance of the target battery cell based on an amount in change of the voltage of the target battery cell during a time period after a predetermined time elapses from a time when the switching element is turned on (S480),
wherein in the turning on of the target switching element, a plurality of switching elements corresponding to a plurality of target battery cells, which are selected from among a plurality of battery cells (SW-1, ..., SW-N) constituting a battery stack (14), are controlled together so that cell balancing for the plurality of target battery cells is performed at the same time, and
wherein in the determining of the alternating current internal resistance, the internal resistances of the plurality of target battery cells are determined based on simultaneously measured voltages.

## FIG. 1

## FIG. 2

**FIG. 3**

START

Measure Voltage Of Battery
Cell To Perform Balancing    —S400

Turn On Switching Element Of Passive Balancing
Circuit Corresponding To Battery Cell    —S420

Measure Voltage Of Battery Cell After
Switching Element Is Turned On    —S440

Determine ACIR Of Battery Cell
Based On Measured Voltages    —S460

Determine DCIR Of Battery Cell
Based On Measured Voltages    —S480

END

# FIG. 4

START

Open PRA Relay —S500

Group Odd-Numbered Battery Cells
And Even-Numbered Battery Cells —S510

S520

Identify
Group Including Highest Voltage
Cell

Even-Numbered Group

Odd-Numbered Group

Perform Cell Balancing For
Odd-Numbered Cell Group —S540

Perform Cell Balancing For The
Even-Numbered Cell Group
S530

Measure Instantaneous
Voltage Change —S542

Measure Instantaneous
Voltage Change
S532

Perform Cell Balancing For
Even-Numbered Cell Group —S544

Perform Cell Balancing For
Odd-Numbered Cell Group
S534

Measure Instantaneous
Voltage Change —S546

Measure Instantaneous
Voltage Change
S536

Calculate ACIR For Each SOC —S550

Compare SOH Data For Each
Temperature And SOC —S560

Estimate SOH —S570

END

*FIG. 5*

Europäisches Patentamt

European Patent Office

Office européen des brevets

# EUROPEAN SEARCH REPORT

Application Number

EP 23 18 8726

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/288520 A1 (ABDEL-MONEM MOHAMED [BE] ET AL) 19 September 2019 (2019-09-19) | 1,3,5 | INV.<br>H02J7/00 |
| A | * paragraph [0032] – paragraph [0179] * | 2,4 | |
| Y | WANG YIPEI ET AL: "An SMPS-Based Lithium-Ion Battery Test System for Internal Resistance Measurement", IEEE TRANSACTIONS ON TRANSPORTATION ELECTRIFICATION, IEEE, vol. 9, no. 1, 28 May 2022 (2022-05-28), pages 934-944, XP011934725, DOI: 10.1109/TTE.2022.3178981 [retrieved on 2022-05-30] * page 937 – page 938 * | 1,3,5 | |
| Y | US 2019/170831 A1 (SADA TOMOKAZU [JP]) 6 June 2019 (2019-06-06) * paragraph [0007] – paragraph [0033] * | 1,5 | |
| A | PHAM VAN-LONG ET AL: "A Low Cost and Fast Cell-to-Cell Balancing Circuit for Lithium-Ion Battery Strings", ELECTRONICS, vol. 9, no. 2, 1 February 2020 (2020-02-01), page 248, XP093131429, Basel, Switzerland ISSN: 2079-9292, DOI: 10.3390/electronics9020248 * page 4 – page 6 * | 1-5 | TECHNICAL FIELDS SEARCHED (IPC)<br><br>H02J<br>G01R |

The present search report has been drawn up for all claims

| Place of search | Date of completion of the search | Examiner |
|---|---|---|
| Munich | 15 February 2024 | Jonda, Sven |

EPO FORM 1503 03.82 (P04C01)

## ANNEX TO THE EUROPEAN SEARCH REPORT
## ON EUROPEAN PATENT APPLICATION NO.

EP 23 18 8726

This annex lists the patent family members relating to the patent documents cited in the above-mentioned European search report.
The members are as contained in the European Patent Office EDP file on
The European Patent Office is in no way liable for these particulars which are merely given for the purpose of information.

15-02-2024

| Patent document cited in search report | | Publication date | Patent family member(s) | | Publication date |
|---|---|---|---|---|---|
| US 2019288520 | A1 | 19-09-2019 | EP | 3455917 A1 | 20-03-2019 |
| | | | ES | 2913252 T3 | 01-06-2022 |
| | | | PL | 3455917 T3 | 13-06-2022 |
| | | | US | 2019288520 A1 | 19-09-2019 |
| | | | WO | 2017194790 A1 | 16-11-2017 |
| US 2019170831 | A1 | 06-06-2019 | CN | 109690337 A | 26-04-2019 |
| | | | JP | 6883742 B2 | 09-06-2021 |
| | | | JP | WO2018051613 A1 | 27-06-2019 |
| | | | US | 2019170831 A1 | 06-06-2019 |
| | | | WO | 2018051613 A1 | 22-03-2018 |

EPO FORM P0459

For more details about this annex : see Official Journal of the European Patent Office, No. 12/82